# EUROPEAN PATENT APPLICATION

(11) **EP 4 722 748 A1**
(43) Date of publication of application: **08.04.2026**
(21) Application number: 24205123.3
(22) Date of filing: 07.10.2024
(51) Int. Cl.: G01R 33/035, G01Q 60/50, G01R 33/00, G01R 33/12

(54) **SUPERCONDUCTING SENSOR DEVICE AND CANTILEVER STRUCTURE FOR A SCANNING PROBE COMPRISING SUCH SUPERCONDUCTING SENSOR DEVICE**

(71) Applicant: Quantamap B.V., 2333 CG Leiden (NL)
(72) Inventor: Lahabi, Kaveh, 2333 CG Leiden (NL)
(74) Representative: De Vries & Metman

(57) **Abstract**

A cantilever structure for a scanning sensor probe is described wherein the cantilever structure includes an elongated support substrate; a 3D point shaped structure at a distal end of the elongated support substrate, the 3D point shaped structure including at least one facet and an apex forming a tip of the cantilever structure, the surface of the facet having an angular orientation with the surface of the elongate support substrate; and, a superconducting sensor device comprising one or more Josephson junctions formed on the surface of the facet.

## Description

### Technical field

The embodiments relate to superconducting sensor device and cantilever structure for a scanning probe comprising such superconducting sensor device, and, in particular, though not exclusively, to a superconducting sensor device, such as superconducting quantum interference device (SQUID), comprising superconducting normal metal superconducting Josephson junctions and a cantilever structure comprising such superconducting sensor device.

### Background

Scanning probe techniques based on superconducting devices, such as a Josephson junctions, is a magnetic imaging technique combining high field sensitively with nanometer-scale spatial resolution. For example, superconducting quantum interference devices (SQUID) may be used to realize a SQUID-based scanning probe technique. In such scheme, a SQUID-on-tip probe, i.e. nanometer-scale SQUID structures fabricated on the tip of the scanning probe, is used to scan an area of a sample. Wyss et al., in their article Magnetic, thermal, and topological imaging with a nanometer-scale SQUID on cantilever scanning probe, Phys. Rev. Applied 17, 034002, 1 March 2022, describe such SQUID-on-tip probe based on Dayem bridge type Josephson junctions using focussed ion beam milling.

One problem related to known SQUID-on-tip probes, such as described by Wyss et al., is that it can only measure the out-of-plane component of the total magnetic field from a sample surface. However, the signal generated by electrical currents and magnetic materials also includes an in-plane component. For example, the in-plane signal carries important information for the imaging of magnetic materials and electrical currents (e.g., in a superconducting qubit chip). Further, another problem related to such SQUID-on-tip probes is that Dayem bridge Josephson junctions have I-V curves exhibiting hysteresis, which makes the SQUID difficult to operate. Techniques to solve this problem require a more complex fabrication process.

Hence, from the above it follows that there is a need in the art for improved superconducting sensor device and cantilever structure for a scanning probe comprising such superconducting sensor device.

### Summary

As will be appreciated by one skilled in the art, aspects of the present invention may be embodied as a system, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Functions described in this disclosure may be implemented as an algorithm executed by a microprocessor of a computer. Furthermore, aspects of the present invention may take the form of a computer program product embodied in one or more computer readable medium(s) having computer readable program code embodied, e.g., stored, thereon.

It is an objective of the embodiments in this disclosure to reduce or eliminate at least one of the drawbacks known in the prior art.

In a first aspect, the embodiments may relate to a cantilever structure for a scanning sensor probe including: an elongated support substrate; a 3D point shaped structure at a distal end of the elongated support substrate, the 3D point shaped structure including at least one facet and an apex forming a tip of the cantilever structure, the surface of the facet having an angular orientation with the surface of the elongate support substrate; and, a superconducting sensor device comprising one or more Josephson junctions formed on the surface of the facet.

In an embodiment, the elongated support structure is configured as a mechanical resonator (such a tuning fork, or a length extension resonator),

In an embodiment, the elongated support structure is a flexible beam.

Hence, a superconducting sensor device comprising one or more Josephson junctions, such as a SQUID, may be formed on the surface of the tilted facet of the 3D point shaped structure that forms the tip of the cantilever structure. This way, the superconducting sensor device makes a non-zero, non-orthogonal angle with a surface of a sample and/or with the surface of the elongated support substrate of the cantilever structure. As a result, a Josephson junction or a SQUID that is formed on the facet is sensitive to magnetic fields both parallel to the surface of the sample and perpendicular to the surface of the sample. In other words, due to its orientation on the tip (tilted relative to the scanning surface), a Josephson junction or a SQUID can both pick up out-of-plane and in-plane fields.

In an embodiment, the elongated support substrate may be configured as a mechanical resonator for resonant readout of deflections of the a tip of the cantilever structure. In an embodiment, the mechanical resonator may include one or more flexible membranes and/or beams; or, the mechanical resonator including one or more rigid membranes and/or beams which are configured as a rigid tuning fork.

In an embodiment, the angle between the surface of the facet on which the superconducting sensor device is formed and the surface of the substrate of the cantilever structure may be between 10° and 80°, more typically between about 20° and 70°.

In an embodiment, the 3D point shaped structure may be a 3D polygon shaped structure, preferably a polygon-based pyramid structure, more preferably a triangular pyramid, a square pyramid, a rectangular pyramid, a pentagonal pyramid, a hexagonal pyramid, or an octagonal pyramid structure.

In an embodiment, each of the one or more Josephson junctions may include two superconducting electrodes electrically connected by a nano constriction.

In an embodiment, the nano constriction may be a normal-metal nano constriction.

In an embodiment, each of the one or more Josephson junctions may be formed in a normal-metal superconducting multilayer thin-film structure formed on the facet of the point shaped structure.

In an embodiment, the superconductor electrodes may be formed over normal metal electrodes wherein the normal metal electrodes and the nano constriction are formed in the same thin-film normal-metal layer.

Hence, SNS Josephson junctions may be formed in a normal-metal superconducting multilayer thin-film structure. These SNS Josephson junctions exhibit no hysteresis in the I-V curves so that these SNS Josephson junctions can be used in scanning sensor probe schemes.

In an embodiment, the thickness of the normal-metal thin-film layer may be between 10 nm and 100 nm.

In an embodiment, the nano constriction may have a width between 20 nm and 200 nm and a length between 10 nm and 100 nm.

In an embodiment, the normal metal layer may comprise one or more metals, each of the metals do not have a superconducting phase above 2.5 Kelvin.

In an embodiment, the normal metal layer may comprise or may consist of a metal selected from Cu, Ag, Au, Pt, Al, Cr, W, Pd, Ru, Re, In, Ti or a metal alloy including a combination of two or more metals selected from Cu, Ag, Au, Pt, Al, Cr, W, Pd, Ru, Re, In, Ti.

In an embodiment, the thickness of the superconducting thin-film layer may be between 5 and 200 nm.

In an embodiment, the superconducting thin-film layer may comprise at least one of Al, Nb, NbTi, NbZr, NbC, WC, MoRe, MoGe, MoSi, TiN, Ta and Pb.

In an embodiment, the superconducting sensor device may be a single Josephson junction or a superconducting quantum interference device (SQUID).

In a further aspect, the embodiments may relate to a scanning sensor probe comprising a cantilever structure according to any one of embodiments as referred above.

In another aspect, the embodiments may relate to a method of manufacturing a superconducting sensor device for a scanning sensor probe comprising:
In yet a further aspect, the embodiments may relate to a method of manufacturing a superconducting sensor device for a scanning sensor probe comprising: forming a normal-metal thin-film layer over a surface of an elongated support substrate having a 3D polygon shaped structure at its distal end, the polygon shaped structure including at least one facet and an apex forming a tip of the cantilever structure, the surface of the facet having an angular orientation with the surface of the elongate support substrate; forming a superconducting thin-film layer over the normal-metal thin film layer to form a normal-metal superconducting thin-film multilayer over the surface of the elongate support substrate and the surface of the facet; forming at least two electrode structures connected to a planar loop structure in the thin-film multilayer, the planar loop structure being formed in the thin-film multilayer covering the facet; and, forming at least two superconducting normal-metal superconducting (SNS) Josephson junctions connected in parallel in the thin-film planar loop structure, the forming of each of the two SNS Josephson junctions including: forming a trench across the width of the planar loop structure by etching through the superconducting thin-film to expose part of the normal-metal thin film; and, forming a nano-constriction in the normal-metal thin film by etching part of the exposed normal-metal thin film in the trench.

In an aspect, the embodiments relate to a method of manufacturing a superconducting sensor device for a scanning sensor probe comprising:
providing elongated support substrate having a 3D point shaped structure at its distal end, the point shaped structure including at least one facet and an apex forming a tip of the cantilever structure, the surface of the facet having an angular orientation with the surface of the elongate support substrate; forming a normal-metal thin-film layer and a superconducting thin-film layer may over the surface of the elongated support substrate and surface of the facet to form a normal-metal superconducting thin-film multilayer.
forming least two electrode structures in the thin-film multilayer by forming a trench in the thin-film multilayer such that the surface of the elongated support substrate and surface of the facet are exposed, the trench extending from the base of the elongated substrate to a junction region at the facet of the 3D polygon shaped structure, preferably the trench being formed using FIB milling to etch through the superconducting and the normal metal layer.
forming a superconducting planar loop structure of a SQUID, the formation including forming hole and one or more further trenches formed around the hole in the thin-film multilayer in the junction region superconducting
forming in the superconducting planar loop structure at least two SNS Josephson junctions connected in parallel, wherein the formation of each of the two SNS Josephson junctions includes etching a trench over the width of the superconducting loop until the normal metal layer is exposed and reducing the width of the normal metal in the trench to form a nano-constriction in the normal metal layer.

In an aspect, the embodiments may relate to one or more Josephson junctions formed in a normal-metal superconducting multilayer thin-film structure provided over a substrate, each of the one or more Josephson junctions including two superconducting electrodes electrically connected by a normal-metal nano-constriction.

In an aspect, the embodiments may relate to a SQUID comprising a planar superconducting loop, the superconducting loop comprising at least two Josephson junctions connected in parallel, the SQUID being formed in a normal-metal superconducting multilayer thin-film structure provided over a substrate, wherein each of the one or more Josephson junctions include two superconducting electrodes electrically connected by a normal-metal nano-constriction.

In an embodiment, the one or more Josephson junctions may be formed directly in the normal-metal superconducting multilayer thin-film structure based on a focussed ion beam technique.

In an embodiment, the superconductor electrodes may be formed over normal metal electrodes and the normal metal electrodes and the nano constriction may be formed in the same thin-film normal-metal layer.

In an embodiment, the thickness of the normal-metal thin-film layer may be between 5 nm and 200 nm.

In an embodiment, the nano constriction may have a width between 10 nm and 450 nm and a length between 10 nm and 200 nm.

In an embodiment, the normal metal layer may ocmprise one or more metals, each of the metals do not have a superconducting phase above 2.5 Kelvin.

In an embodiment, the normal metal layer may be made of a metal selected from Cu, Ag, Au, Pt, Al, Cr, W, Pd, Ru, Re, In, Ti or a metal alloy including a combination of two or more metals selected from Cu, Ag, Au, Pt, Al, Cr, W, Pd, Ru, Re, In, Ti.

In an embodiment, the thickness of the superconducting thin-film layer may be between 5 and 200 nm.

In an embodiment, the superconducting thin-film layer may comprise at least one of Al, Nb, NbTi, NbZr, NbC, WC, MoRe, MoGe, MoSi, TiN, Ta and Pb.

In an embodiment, the superconducting sensor device is a single Josephson junction or a superconducting quantum interference device (SQUID).

In a further aspect, the embodiments may relate to a method of manufacturing superconducting quantum interference device comprising:
forming a normal-metal superconducting thin-film bilayer on a substrate;
forming a thin-film planar loop structure in the thin-film bilayer; and,
forming two superconducting normal-metal superconducting (SNS) Josephson junctions in the thin-film planar loop structure, the forming of each of the two SNS Josephson junctions including:
   forming a trench across the width of planar loop structure by etching through the superconducting thin-film to expose part of the normal-metal thin film; and,
   forming a nano-constriction in the normal-metal thin film by etching part of the exposed normal-metal thin film in the trench.

In an embodiment, the thin-film planar loop structure, the trench and/or the nano-constriction is/are formed in the thin-film bilayer using focused ion beam milling, preferably a direct write focused ion beam milling technique.

In an embodiment, forming the normal-metal superconducting thin-film bilayer includes depositing a normal-metal thin-film layer and depositing a superconductor thin-film layer on the normal-metal layer.

In an embodiment, the elongated substrate comprises a quartz tuning fork or a length extension resonator. The quarts tuning fork or the length extension resonator may be used in an electrical readout of scanning probe. Such fully electrical readout of the sample topography does not require a laser beam and is thus particularly useful for scanning probes that operate at cryogenic temperatures.

The embodiments will be further illustrated with reference to the attached drawings, which schematically will show embodiments according to the invention. It will be understood that the invention is not in any way restricted to these specific embodiments.

### Brief description of the drawings

Aspects of the invention will be explained in greater detail by reference to exemplary embodiments shown in the drawings, in which:
**Fig. 1A-1E** depict schematics of a method for fabricating a superconducting device comprising one or more Josephson junction according to an embodiment;
**Fig. 2A-2D** depict schematics of superconducting devices including one or more Josephson junctions according to various embodiments;
**Fig. 3A** and **3B** represent scanning electron microscopy images of a SQUID according to an embodiment;
**Fig. 4A-4F** show a method of manufacturing a superconducting sensor device for a scanning sensor probe according to an embodiment;
**Fig. 5A-5E** depict a method of manufacturing a superconducting sensor device according to an embodiment;
**Fig. 6A** and **6B** are scanning electron microscopy images of SQUIDs integrated on a tip of scanning probe according to various embodiments;
**Fig. 7** depicts the response of a SQUID according to an embodiment as a function of magnetic field for different bias currents;
**Fig. 8** depicts the resistance measured as a function of temperature for a SQUID according to an embodiment;
**Fig. 9** and **10** depict non-hysteretic current-voltage characteristics of a SQUID according to an embodiment.

### Description of the embodiments

The embodiments in this disclosure describe superconducting devices, in particular superconducting sensor devices such as a single Josephson junction or a superconducting quantum interference device (SQUIDs), in particular SQUIDs that are integrated on tips for scanning probes for, e.g., atomic force microscopy or scanning tunnelling microscopy, as well as methods for fabricating the same.

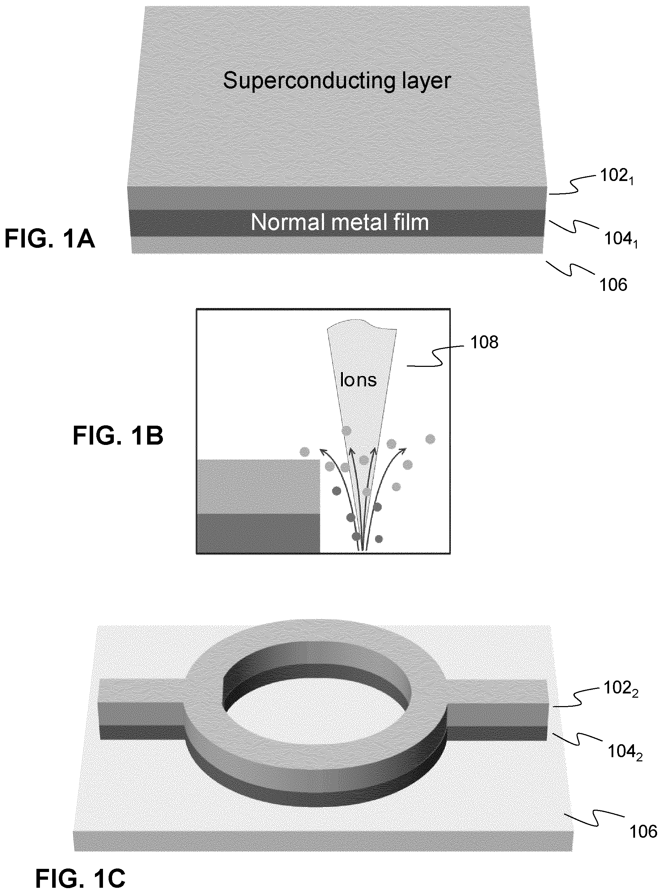

**Fig. 1A-1E** depict schematics of a method for fabricating a superconducting device comprising one or more Josephson junction according to an embodiment. In particular, the figures illustrate the fabrication of superconducting normal-metal superconducting SNS Josephson junctions and SQUIDs with nano-constricted normal metal weak links. The process may start with a superconductor (S) - normal metal (N) multilayer film is deposited (in-situ) in a vacuum chamber. The superconductor layer **102₁** may be deposited directly on top of a normal metal **104** which is formed on a substrate **106.** In an embodiment, the superconducting thin-film layer may comprise at least one of a Nb, NbTi, NbZr, NbC, WC, MoRe, MoGe, MoSi, TiN, Ta or a Pb thin film layer. In further embodiment, the superconducting thin-film layer may have a multilayer structure including two or more superconducting thin-film layers as mentioned above.

The normal metal thin-film may be of a metal or a metal alloy with a high thermal conductivity (e.g., Cu and Ag, Au and their alloys). More generally, in an embodiment, the normal metal layer in include a Cu, Ag, Au, Pt, Al, Cr, W, Pd, Ru, Re, In or Ti thin film layer. Alternately, in a further embodiment, the normal metal layer may be made of an alloy including a combination of two or more metals selected from Cu, Ag, Au, Pt, Al, Cr, W, Pd, Ru, Re, In, Ti. In further embodiments, the thin film normal metal layer may have a multilayer structure including two or more metal or metal alloy layers as mentioned above, which may be superconducting through proximity effect at the interface with the superconductor despotised on top. The proximity effect only occurs below the transition temperature of the superconducting material.

In some embodiments, Al may be used as a superconducting material. The normal metal superconductor multilayer may also include one or more additional sticking layers for allowing good sticking of the normal layer on the substrate. Additionally, the multilayer may include one or more capping layers to protect the superconducting layer.

For example, a thin sticking layer (e.g., Cr or Ti) of a thickness smaller than 10 nm may be deposited before the normal-metal layer is deposited to ensure uniform coverage of the subsequent superconductor thin-film layer. Similarly, a capping layer (e.g., Pt, Au, carbides) may be deposited on top of the superconductor layer to preserve its quality and delay corrosion in ambient conditions. Neither the sticking layer nor the capping layer are required to have high electrical or thermal conductivity.

**Fig. 1B** and **1C** illustrate the structuring of the normal-metal superconductor multilayer using an etching technique to etch way parts of the normal-metal superconductor multilayer until the underlying substrate is exposed. In particular, focused ion beam **108** (FIB) milling may be used to carve out a desired geometry (in this example a circular loop) by etching the multilayer. The process produces a sharply defined lateral multi-layer nanostructure **102₂,104₂** on the substrate **106** with highly uniform edges as shown in **Fig. 1C****.**

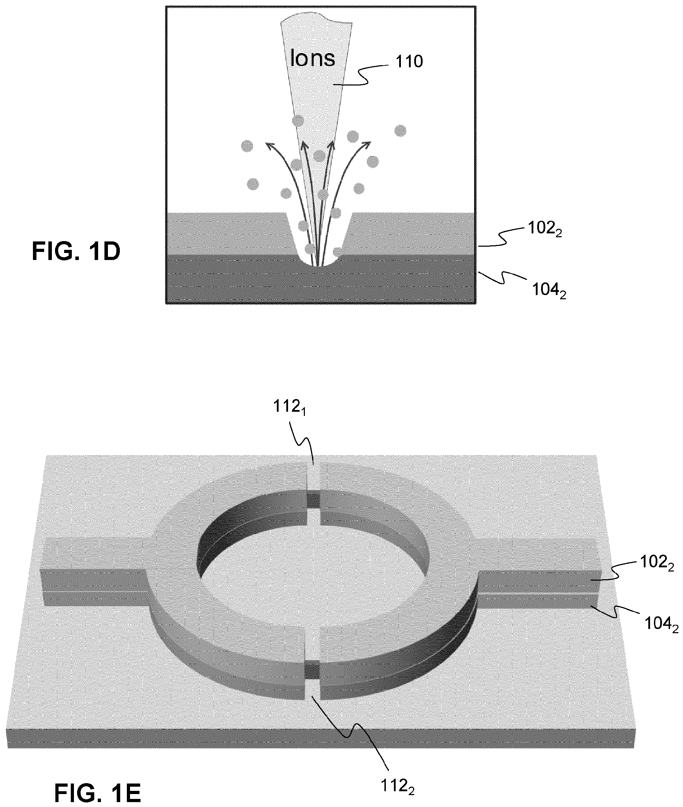

**Fig. 1D** and **1E** illustrate the formation of nano-constricted normal metal weak links using FIB. By repeatedly scanning the FIB in a straight line over a part of the multilayer nanostructure in which a Josephson junction is to be formed. The repeated scanning results in a formation of a narrow trench in the superconducting layer, which separates the top (superconducting) layers by the normal metal film beneath. The trench exposes the underlying normal metal layer. Repeated scanning of the FIB milling is used to form a nano-constriction **112_{1,2}** in the normal metal. When removing material from the top (superconducting) layer, each scan makes the exposed normal metal layer in the trench more constricted laterally (along the scan direction). This is because the atoms at the edges of the structure can escape the trench more easily than those in the middle, and therefore have a higher etch rate. This enables precise control of the thickness and lateral dimensions of the normal metal nano-constriction during FIB milling. This control may include controlling the number of FIB scans. The FIB milling may be controlled produce nano-constrictions of a predetermined length L and width W. SNS Josephson junctions that are fabricated based on the process depicted in **Fig. 1A-1D** have substantial advantages over known weak link Josephson junctions that are fabricated with FIB.

The small lateral dimensions of the normal nano-constriction and sharply defined edges of the previously structured film produces a specific depth profile for the trench, providing high performance sensitivity the Josephson junctions and SQUIDs that can be realized based on the fabrication method.

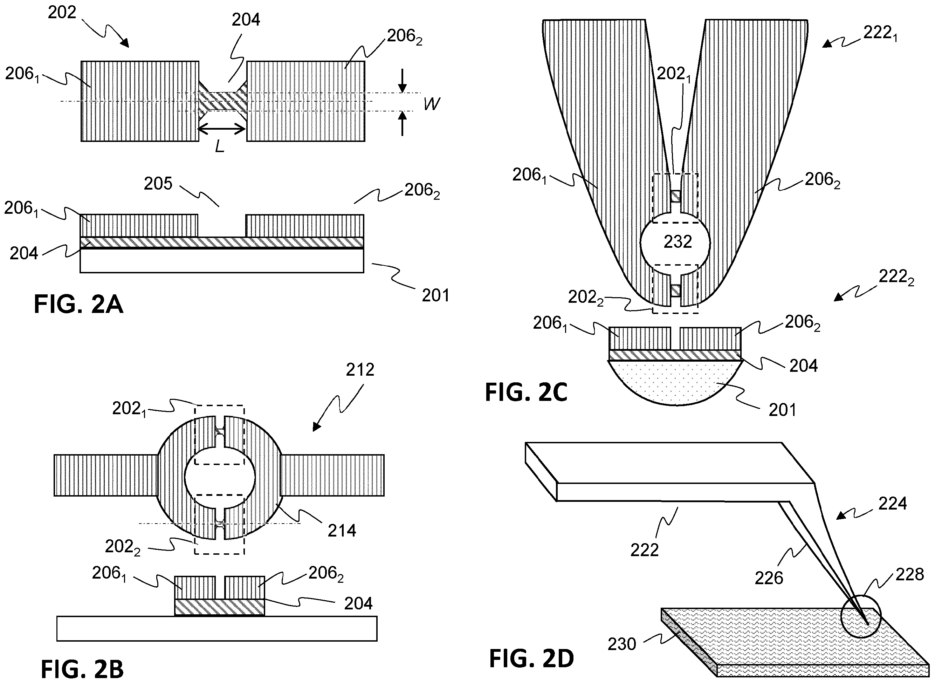

**Fig. 2A-2D** depict schematics of superconducting devices including one or more Josephson junctions according to various embodiments. The superconducting devices may be fabricated using the method of fabrication as explained with reference to **Fig. 1A-1** **D.** **Fig. 2A** depicts a top view and a cross-sectional view of a superconductor - normal metal - superconductor (SNS) Josephson junction **202** according to an embodiment. The SNS Josephson junction may be formed in a normal-metal superconducting multilayer using focussed ion beam etching. The SNS Josephson junction may be part of a superconducting quantum interference (SQUID) device as shown in **Fig. 2B** and **2C** respectively. As shown in **Fig. 2A** Josephson junction **202** may comprise two superconducting electrodes **206_{1,2}** separated by a trench **205.** The superconducting electrodes may be provided on a normal-metal layer **204.** Both the normal metal and the superconductor layers may be provided as a thin film on a substrate **201,** wherein the thickness of these layers is between 5 and 200 nm.

At location of the trench the width of the normal metal layer is narrowed down to form a nano-constriction characterized by a width *W* and a length *L* as indicated in the figure. FIB milling may be used to create a nano-constriction in the normal metal thin film layer wherein the length of the normal-metal nano-constriction may be selected between 10 nm and 200 nm and wherein the width of the normal-metal nano-constriction may be selected between 10 nm and 450 nm. The resistance of the normal-metal nano-constriction may be selected to have a resistance between 0.1 and 20 Ω.

**Fig. 2B** schematically depicts a superconducting device according to an embodiment. In particular, the figure illustrates a top view and a cross section of a SQUID **212** comprising a superconducting loop **214** and two parallel SNS Josephson junctions **202_{1,2}** which may be fabricated using the fabrication scheme as described with reference to **Fig. 1A-1D****.** The superconducting loop may have an effective diameter between 50 and 2000 nm. For example, the superconducting loop may have an outer-diameter between 100 and 3000 nm and an inner diameter between 20 nm and 1000 nm. Although depicted here as a circle, the SQUID loop can also have different shapes, e.g., rectangular, square or polygon. Depending on the superconducting material used, the SQUID may have a critical current in the range between 5 µA and 1 mA. As will be shown below in more detail the SNS Josephson junctions described with reference to the embodiments in this disclosure exhibit low or no hysteresis in their current-voltage (I-V) graphs, which is advantageous for reliably handing a Josephson junction or a SQUID as a magnetic sensor. The transfer function of a SQUID fabricated based on the fabrication method of **Fig. 1A-1D** (i.e., the voltage a SQUID produces as a function of a change in magnetic flux) can be in the range from 1000 µV/Φ₀ to 20,000 µV/Φ₀.

**Fig. 2C** and **2D** schematically depict superconducting sensor device according to further embodiments of the invention. **Fig. 2D** illustrates a cantilever structure for a scanning sensor probe which includes a superconducting sensor device integrated on the 3D point structure that forms the tip of the scanning probe. The cantilever structure includes an elongated support substrate **222** and a 3D point shaped structure **224** at a distal end of the elongated support substrate. As shown in **Fig. 2D****,** the 3D point shaped structure may include at least one facet **226** and an apex **228** forming a tip of the cantilever structure, wherein the surface of the facet may have an angular orientation with the surface of the elongate support substrate and with the surface of the sample **230** that needs to be scanned by the scanning sensor probe.

A superconducting sensor device comprising one or more Josephson junctions, such as a SQUID, may be formed on the surface of the tilted facet (due to its size, the SQUID structure not visible in the cantilever structure in **Fig. 2D**) of the 3D point shaped structure so that the superconducting sensor device makes a non-zero, non-orthogonal angle with a surface of a sample **230** and/or with the surface of the elongated support substrate of the cantilever structure. In an embodiment, the angle between the surface of the facet on which the superconducting sensor device is formed and the surface of the support substrate of the cantilever structure may be between 10° and 80°, more typically between about 20° and 70°.

As a result, a Josephson junction or a SQUID that is formed on the facet is sensitive to magnetic fields both parallel to the surface of the sample and perpendicular to the surface of the sample. In other words, due to its orientation on the tip (tilted relative to the surface), a Josephson junction or a SQUID can also pick up in-plane fields. Conventional SQUID-on-tip probes only couple to the out-of-plane component of the local magnetic field. It is however advantageous to also probe the in-plane field (e.g., the in-plane fields are better for mapping the local current distribution/flow pattern and magnetic structures with in-plane magnetization).

The above-described advantages of a superconducting sensor device integrated on a tilted facet of the 3D point shaped structure at the distal end of a cantilever structure for a scanning probe (i.e. the ability to sense both in-plane and out of plane components of the local magnetic field) can in principle be achieved using any type of superconducting Josephson device, including nano-constriction type Josephson junctions known in the prior art.

Although other known quantum magnetic sensing techniques, such as quantum magnetometers based on nitrogen-vacancy (NV) centres allow detection of both in-plane and out of plane components of the local magnetic field, these techniques cannot be used at cryogenic temperatures because these NV centres require an optical readout using lasers in combination with microwave excitation. In such scheme the sensor has to be illuminated using a laser beam thereby inevitably heating up the sensor. The local heating of the sample by the laser beam is highly undesirable for low-temperature use, and is detrimental to the operation of quantum circuits (e.g., superconducting qubits), which are sensitive to thermal fluctuations and excitations from photons. Moreover, implementing an optical readout in combination with microwave excitation in a cryogenic environments is very challenging and complex.

The integration of a superconducting sensor device on a tilted facet of the 3D point shaped structure at the distal end of a cantilever structure mitigate the above-mentioned problems because the cantilever structure is fully compatible with a relatively simple, fully electrical readout scheme for the superconducting sensor device, which can be operated at very low temperatures. In particular, the elongated support substrate can be readily configured as a resonator for resonant readout of deflections of the tip of the cantilever structure when it is used as a scanning probe.

In an embodiment, the elongated support substrate may be configured as a mechanical resonator for resonant readout of the scanning probe. In an embodiment, the mechanical resonator may include flexible membranes and/or beams. In another embodiment, the mechanical resonator may include one or more rigid membranes and/or beams configured as a rigid tuning fork.

In some embodiments, the superconducting sensor device, integrated on the tilted facet of the 3D point shaped structure at the distal end of a cantilever structure, may include one or more SNS Josephson junctions as described with reference to the embodiments in this disclosure. This is schematically shown in **Fig. 2C****,** illustrating a top view **222₁** and a cross-sectional view **222₂** of a SQUID on the face of a point shape structure at the distal end of a cantilever structure for a scanning probe. The 3D point shape structure forms a tip of a sensing probe of, e.g., an atomic force microscope, scanning tunnelling microscope, or similar device. A normal metal - superconductor multilayer may be formed on a (typically pre-existing) tip and electrodes **206_{1,2}** are formed in the multilayer using FIB milling. Further, FIB milling is used to form a planar loop structure **232** and two parallel normal-metal nano-constrictions **202_{1,2}** that form the two parallel Josephson junctions. Although the depicted embodiment comprises multiple SNS Josephson junctions **202_{1,2}**, other embodiments may comprise only a single SNS Josephson junction.

In some embodiments, a superconducting sensor device comprising one or more SNS Josephson junctions may be integrated on a facet of the 3D point shaped structure at the distal end of a cantilever structure, wherein the facet is substantially parallel to the surface of a sample **230** and/or with the surface of the elongated support substrate of the cantilever structure. Such cantilever structures are known from Wyss et al., in their article Magnetic, thermal, and topological imaging with a nanometer-scale SQUID on cantilever scanning probe, Phys. Rev. Applied 17, 034002, 1 March 2022. The SNS Josephson junctions as described with reference to the embodiments in this application exhibit very low or even no hysteresis in the I-V curves therefore providing advantageous operation in combination with a reliable and simple fabrication method for fabricating such SQUID on a cantilever scanning probe.

In an embodiment, the elongated substrate may include a quartz tuning fork for providing an electrical readout of the deflection of the sensor probe. In such scheme piezoelectric properties of a single crystal quartz tuning fork are used to perform electric readout of the deflection. In comparison with the optical and piezoresistive readout schemes, the readout based on a tuning fork does not cause heating of the probe.

Such simple electrical readout helps the thermal design of the scanning probe as heat sources are no longer present. Its relative simplicity against other readout schemes enhances reliability, takes developing costs down and makes the AFM more compact, resulting in enhanced mechanical stability against the surrounding environment.

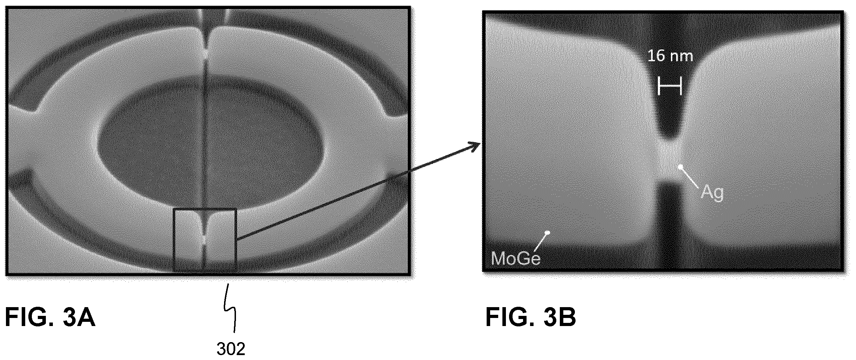

**Fig. 3A** and **3B** represent scanning electron microscopy images of a SQUID according to an embodiment. The SQUID includes a loop comprising two SNS Josephson junctions in parallel, wherein the loop has an inner diameter of 1150 nm and an outer diameter of 1380 nm. The SNS Josephson junction includes a normal metal nano-constriction of about 16 nm length and about 90 nm with. The SQUID is fabricated in a bilayer consisting of a 25 nm Ag (normal metal) layer and a 55 nm MoGe (superconductor) layer on a Si substrate. The SQUID structure in **Fig. 3A** and the trench **302** forming the gap between the superconducting electrodes are created using focussed ion beam milling.

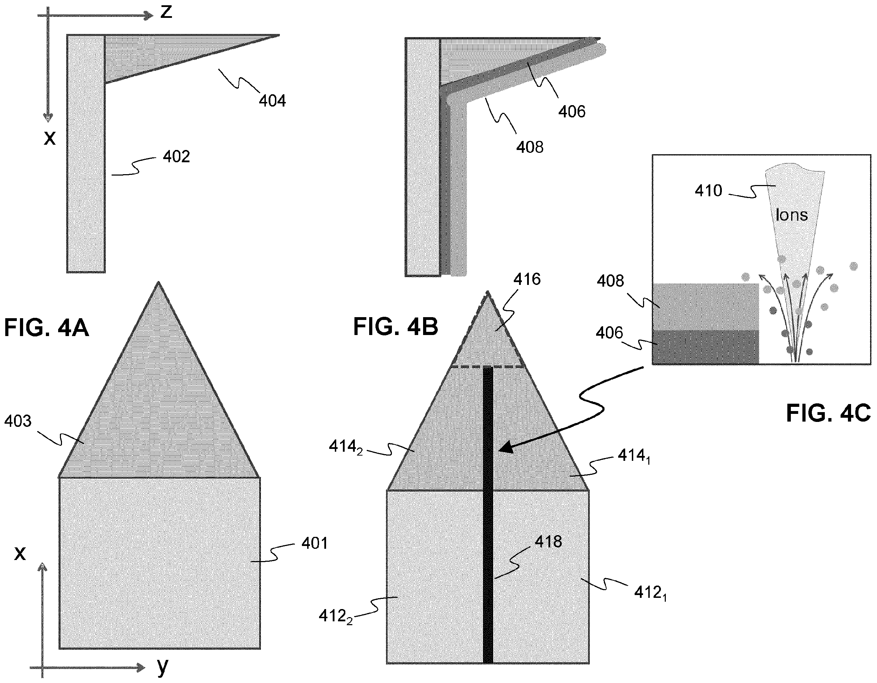

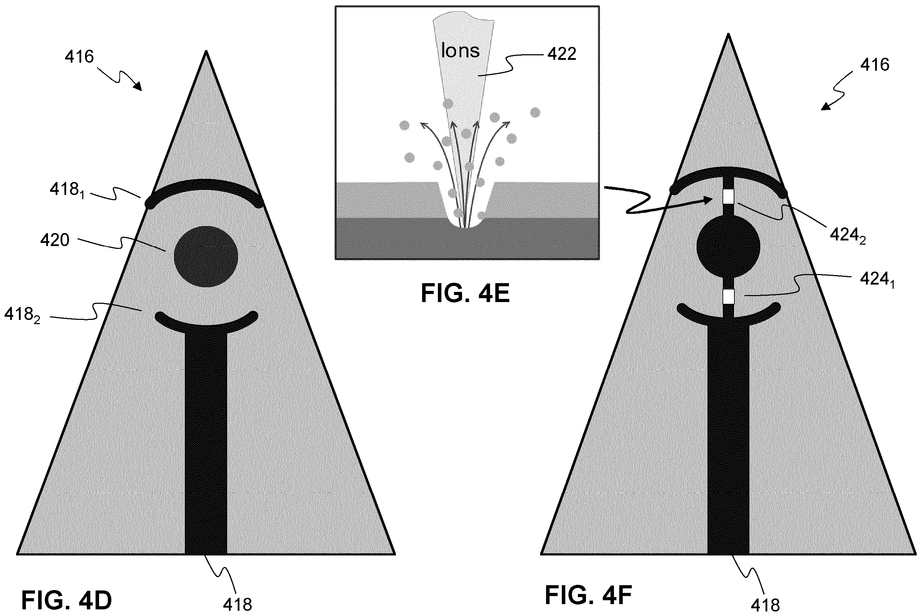

**Fig. 4A-4F** show a method of manufacturing a superconducting sensor device for a scanning sensor probe according to an embodiment. Each of the figures include a cross-section view and a top view of the superconducting sensor device.

As shown in **Fig. 4A****,** the method may start an elongated support substrate **402** having a 3D point shaped structure **404** at its distal end, the point shaped structure including at least one facet and an apex forming a tip of the cantilever structure, the surface **403** of the facet having an angular orientation with the surface **401** of the elongate support substrate. In **Fig. 4B** a normal-metal thin-film layer **406** and a superconducting thin-film layer **408** may be formed over the surface of the elongated support substrate and surface of the facet to form a normal-metal superconducting thin-film multilayer.

Further, at least two electrode structures **412_{1,2}** may be formed in the thin-film multilayer, at least two electrode structures being formed by forming a trench **418** in the thin-film multilayer such that the surface of the elongated support substrate and surface of the facet are exposed, the trench extending from the base of the elongated substrate to a junction region **416** at the facet of the 3D polygon shaped structure. The formation of the trench may be realized using FIB milling **410** through the superconducting and the normal metal layer.

**Fig. 4D** depicts the formation of a superconducting loop of the SQUID which includes the formation of a hole **420** and one or more further trenches **418_{1,2}** formed around the hole in the thin-film multilayer in the junction region. This way a planar superconducting thin film loop structure (a doughnut shaped thin film loop structure having an outer diameter and an inner diameter) of a certain width (i.e. the difference between the outer and the inner diameter) is formed in the thin-film multilayer. Finally, FIB milling **422** is used to form in the superconducting loop least two SNS Josephson junctions **424_{1,2}** connected in parallel, wherein the formation of each of the two SNS Josephson junctions includes etching a trench over the width of the superconducting loop until the normal metal layer is exposed and reducing the width of the normal metal in the trench to form a nano-constriction in the normal metal layer.

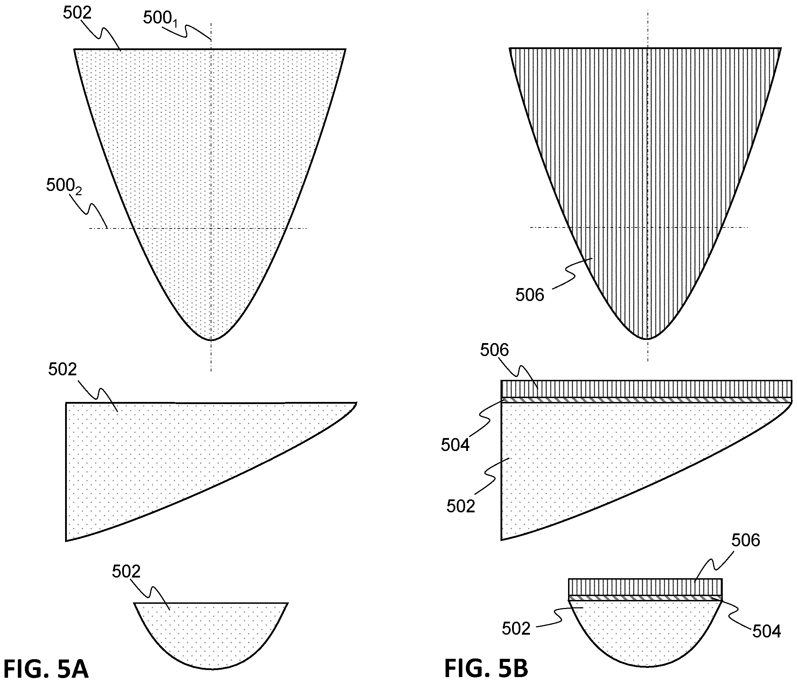

**Fig. 5A-5E** depict a method of manufacturing a superconducting sensor device according to an embodiment. For each figure, the top row shows a top view, the middle row shows a longitudinal cross-section along a central axis **500i** and the bottom row shows a traverse cross-section along an axis **500₂** going through one of the junctions (once the device is finished). **Fig. 5A** depicts part of a 3D point shaped structure at a distal end of the elongated support substrate, which includes a facet **502** having a surface on which a superconducting sensor device, such as a Josephson junction or a SQUID can be formed. The 3D point shaped structure may form the tip of a scanning probe. Any cantilever scanning probe may be used. In some embodiments, the 3D point shaped structure may be a 3D polygon shaped structure that includes at least one facet and an apex. In further embodiment, the 3D point shaped structure may be a polygon-based pyramid structure, such as a triangular pyramid structure, a square pyramid structure, a rectangular pyramid structure, a pentagonal pyramid structure, a hexagonal pyramid structure, or an octagonal pyramid structure.

A normal-metal superconducting thin-film multilayer, including a normal metal thin film layer **504** and a superconducting thin film layer **506** may be formed on the substrate using any suitable deposition method, e.g. sputtering, resulting in a structure as shown in **Fig. 5B****.** The thickness of the normal metal thin-film layer may be between 5 and 200 nm, e.g., between 20 and 160 nm or between 40 and 120 nm. The normal metal may comprise, or consist of or substantially consist of, one or more metals with a high thermal and electrical conductivity, which do not have a superconducting phase above a designed operating temperature the SQUID. Examples of such metals are Cu, Ag, Au, Pt, Al, Cr, W, Pd, Ru, Re, In, Ti, and metallic alloys made from combining two or more of these metals. The thermal conductivity (at the operating temperature) may be at least 100 W/m K.

The thickness of the superconducting thin-film layer **516** may be between 5 and 200 nm, e.g., between 20 and 160 nm or between 40 and 120 nm. The conducting material may comprise, or consist of or substantially consist of, one or more of: Nb, NbTi, NbZr, NbC, WC MoRe, MoGe, MoSi, TiN, Ta and Pb.

In some cases, additional layers may be provided below, above, or in between the thin-film layers of the normal-metal superconducting thin-film multilayer, e.g., to improve adhesion or for protection. For example, if Au is chosen as the normal metal, the Au may be deposited on top of a thin (e.g., 2-5 nm) Cr or Ti layer, to prevent the Au layer from peeling off and/or to improve the uniformity of the layer thickness. The normal metal thin-film layer **514,** the superconducting thin-film layer **516,** and any optional other layers (not shown) may be formed using RF sputtering or any other suitable deposition method.

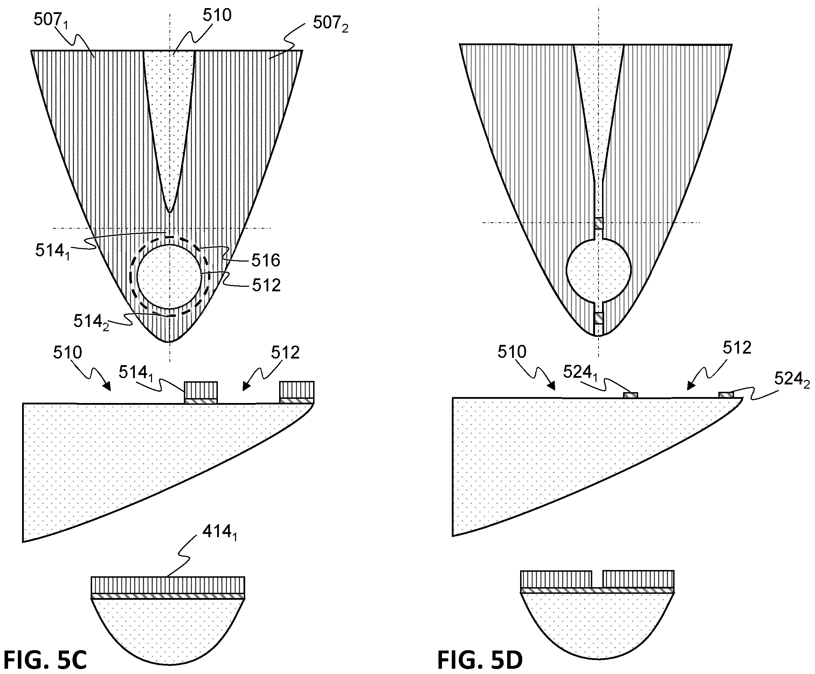

As shown in **Fig. 5C****,** a thin-film planar loop structure 516 is formed in the thin-film multilayer using FIB milling. In the depicted example a trench **510** may be formed that cuts through the entire multilayer (so that the substrate material is exposed) thus forming two electrodes **507_{1,2}**. Furthermore, a hole **512** may be formed, cutting through the entire multilayer to expose the substrate material, forming a SQUID loop. Two bridge parts **514_{1,2}** close the loop and connect the electrodes. The thin-film planar loop structure **516** (the superconducting loop of the SQUID) may have an effective diameter between 50 and 2000 nm, preferably between 100 and 1000 nm.

Superconducting normal-metal superconducting (SNS) Josephson junctions may be formed at the location of the bridge parts **514_{1,2}**. The formation of a SNS Josephson junction includes forming a trench **518** across the each of the bridge parts **514_{1,2}** by etching through the superconducting thin film to expose part of the normal-metal thin film, as shown in **Fig. 5D****.** This step may be performed using focussed ion beam milling.

**Fig. 5E** shows a close-up of the final structure, wherein the exposed normal-metal thin film **524_{1,2}** in the trench **518,** i.e., the normal-metal part of the SNS Josephson junction, comprises a nano-constriction. This nano-constriction can be obtained etching part of the exposed part of the normal-metal thin film, e.g., using focussed ion beam milling, as described in detail with reference to **Fig. 1** and **2****.**

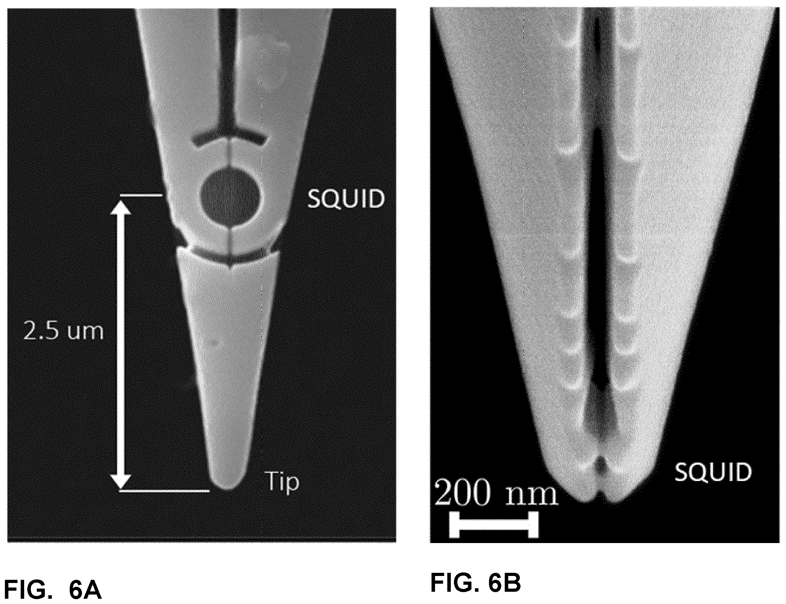

**Fig. 6A** and **6B** are scanning electron microscopy images of SQUIDs integrated on a tip of scanning probe according to various embodiments. **Fig. 6A** shows a SQUID having a loop of a diameter of about 1 µm and two SNS Josephson junctions. Due to its size and the shape of the tip, the SQUID is located at about 2.5 µm from the apex of the tip. **Fig. 6B** shows a SQUID according to an embodiment wherein the loop of the SQUID has a diameter of about 100 nm and two SNS Josephson junction. The dimensions of the SQUID allow the SQUID to be located essentially at the apex of the tip.

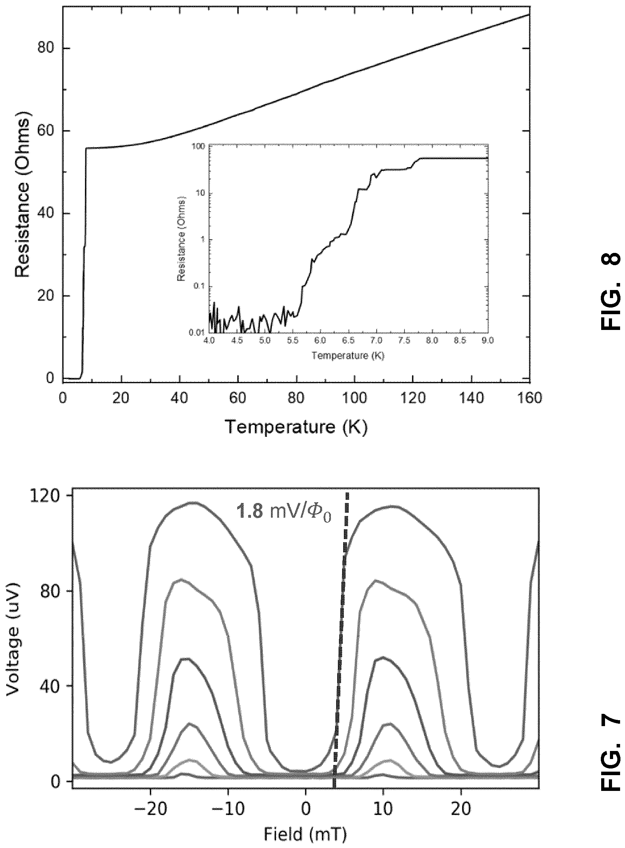

**Fig. 7** depicts the response of a SQUID according to an embodiment as a function of magnetic field for different bias currents. The figure shows that the SQUID exhibits high magnetic transfer function of 1.8 mV/ *Φ*₀ (the dotted line corresponds to the point with maximum field sensitivity). For comparison, literature values for a typical SQUID transfer function are in the range of (10uV-100uV/*Φ*₀).

**Fig. 8** depicts the resistance measured as a function of temperature for a SQUID according to an embodiment. The Nb electrodes become superconducting below 8K, through multiple transitions (different regions of the probe). At 6.5 K the Nb is fully superconducting; the remaining 1.5 Ohm corresponds the resistance of the Cu weak links of the SQUID (their normal state resistance). Below 6.5 K, the Cu nano-constrictions begin to transition through proximity effect, and become fully superconducting below 5.7 K.

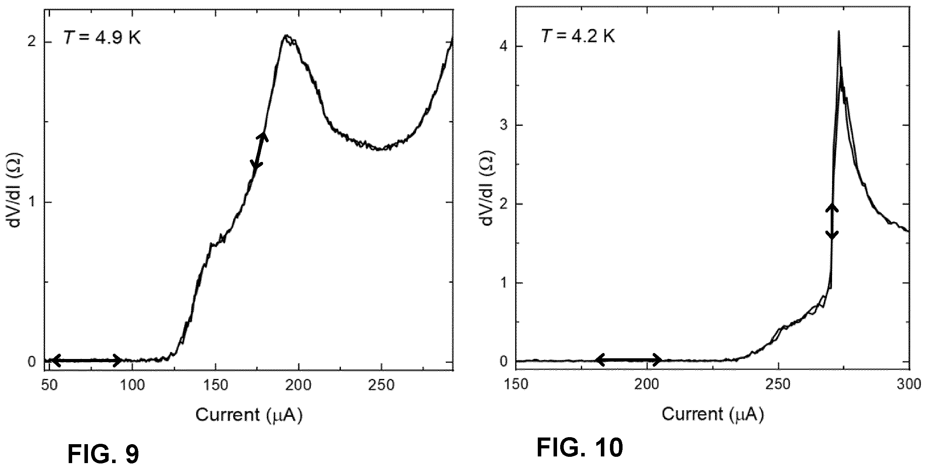

**Fig. 9** and **10** depict non-hysteretic current-voltage characteristics of a SQUID according to an embodiment. The dV/dl measurements were taken while sweeping a DC bias current from 0 to 300 uA and back. Despite going well above the critical current (120 uA at 4.9 K, and 230 uA at 4.2 K), the SQUID exhibits no hysteresis. This is demonstrated by the overlapping traces measured for forward and reverse current sweeps, which are indistinguishable.

In a further embodiment, the elongated support substrate comprises a quartz tuning fork for providing a full-electrical readout of the topography of the sample.

In a further embodiment, the quartz tuning fork may be provided with the 3D point shaped structure at the distal end of one probe while the other is free.

The terminology used herein is for the purpose of describing particular embodiments only and is not intended to be limiting of the invention. As used herein, the singular forms "a," "an," and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof.

The corresponding structures, materials, acts, and equivalents of all means or step plus function elements in the claims below are intended to include any structure, material, or act for performing the function in combination with other claimed elements as specifically claimed. The description of the present invention has been presented for purposes of illustration and description, but is not intended to be exhaustive or limited to the invention in the form disclosed. Many modifications and variations will be apparent to those of ordinary skill in the art without departing from the scope and spirit of the invention. The embodiment was chosen and described in order to best explain the principles of the invention and the practical application, and to enable others of ordinary skill in the art to understand the invention for various embodiments with various modifications as are suited to the particular use contemplated.

## Claims

1. A cantilever structure for a scanning sensor probe including:
an elongated support substrate;
a 3D point shaped structure at a distal end of the elongated support substrate, the 3D point shaped structure including at least one facet and an apex forming a tip of the cantilever structure, the surface of the facet having an angular orientation with the surface of the elongate support substrate; and,
a superconducting sensor device comprising one or more Josephson junctions formed on the surface of the facet.

2. Cantilever structure according to claim 1 wherein the elongated support substrate is configured as a mechanical resonator for resonant readout of deflections of the a tip of the cantilever structure, preferably the mechanical resonator including one or more flexible membranes and/or beams; or, the mechanical resonator including one or more rigid membranes and/or beams which are configured as a rigid tuning fork.

3. Cantilever structure according to claims 1 or 2 wherein the 3D point shaped structure is a 3D polygon shaped structure, preferably a polygon-based pyramid structure, more preferably a triangular pyramid, a square pyramid, a rectangular pyramid, a pentagonal pyramid, a hexagonal pyramid, or an octagonal pyramid structure.

4. Cantilever structure according to claims 1 or 2 wherein each of the one or more Josephson junctions includes two superconducting electrodes electrically connected by a nano constriction, preferably the nano constriction being a normal-metal nano-constriction.

5. Cantilever structure according to claim 4 wherein each of the one or more Josephson junctions are formed in a normal-metal superconducting bilayer thin-film structure formed on the facet of the 3D point shaped structure.

6. Cantilever structure according to claims 4 or 5 wherein the superconductor electrodes are formed over normal metal electrodes and wherein the normal metal electrodes and the nano constriction are formed in the same thin-film normal-metal layer.

7. Cantilever structure according to any of claims 4-6 wherein the thickness of the normal-metal thin-film layer is between 5 nm and 200 nm.

8. Cantilever structure according to any of claims 4-7 wherein the nano constriction has a width between 10 nm and 450 nm and a length between 10 nm and 200 nm.

9. Cantilever structure according to any of claims 4-8 wherein the normal metal layer comprises one or more metals, each of the metals do not have a superconducting phase above 2.5 Kelvin.

10. Cantilever structure according to any of claims 4-9 wherein the normal metal layer is made from a metal selected from Cu, Ag, Au, Pt, Al, Cr, W, Pd, Ru, Re, In, Ti or a metal alloy including a combination of two or more metals selected from Cu, Ag, Au, Pt, Al, Cr, W, Pd, Ru, Re, In, Ti.

11. Cantilever structure according to any of claims 4-10 wherein the thickness of the superconducting thin-film layer is between 5 and 200 nm.

12. Cantilever structure according to any of claims 4-11 wherein the superconducting thin-film layer comprises at least one of Al, Nb, NbTi, NbZr, NbC, WC, MoRe, MoGe, MoSi, TiN, Ta and Pb.

13. Cantilever structure according to any of claims 4-12 wherein the superconducting sensor device is a single Josephson junction or a superconducting quantum interference device (SQUID).

14. A scanning sensor probe comprising a cantilever structure according to any one of claims 1-13.

15. A Method of manufacturing a superconducting sensor device for a scanning sensor probe comprising:
forming a normal-metal thin-film layer over a surface of an elongated support substrate having a 3D point shaped structure at its distal end, the point shaped structure including at least one facet and an apex forming a tip of the cantilever structure, the surface of the facet having an angular orientation with the surface of the elongate support substrate;
forming a superconducting thin-film layer over the normal-metal thin film layer to form a normal-metal superconducting thin-film multilayer over the surface of the elongated support substrate and the surface of the facet;
forming at least two electrode structures connected to a planar loop structure in thin-film multilayer, the planar loop structure being formed in the thin-film multilayer covering the facet; and,
forming at least two superconducting normal-metal superconducting (SNS) Josephson junctions connected in parallel in the thin-film planar loop structure, the forming of each of the two SNS Josephson junctions including:
- forming a trench across the width of the planar loop structure by etching through the superconducting thin-film to expose part of the normal-metal thin film; and,
- forming a nano-constriction in the normal-metal thin film by etching part of the exposed normal-metal thin film in the trench.
